# EUROPEAN PATENT SPECIFICATION

(11) **EP 2 762 462 B1**
(45) Date of publication and mention of the grant of the patent: **23.12.2020**
(21) Application number: 13153848.0
(22) Date of filing: 04.02.2013
(51) Int. Cl.: C04B 35/462, C01G 23/00, C01G 25/00, C01G 33/00, C01G 35/00, C04B 35/468, C04B 35/486, C04B 35/495, C04B 35/626, C04B 35/645, C23C 14/34, C01G 1/02

(54) **Method of forming a target and depositing doped dielectric films by sputtering**
Verfahren zur Bildung eines Target und zur Ablagerung von dotierten dielektrischen Folien durch Sputtering
Procédé de formation d'une cible et de dépôt de films diélectriques dopés par pulvérisation

(43) Date of publication of application: 06.08.2014
(73) Proprietor: NXP USA, Inc., Austin TX 78735 (US)
(72) Inventor: Zelner, Marina, Burlington, Ontario L7L 5P5 (CA); Cervin-Lawry, Andrew Vladimir Claude, Burlington, Ontario L7L 5P5 (CA)
(74) Representative: Miles, John Richard

(56) References cited:
- US-A1- 2003 073 565
- US-A1- 2003 119 656
- US-A1- 2008 152 530
- US-A1- 2011 114 481
- US-A1- 2011 212 382
- US-A1- 2012 147 524
- SUNG-SOO RYU ET AL: "Solid-state synthesis of nano-sized BaTiO3 powder with high tetragonality", JOURNAL OF MATERIALS SCIENCE, KLUWER ACADEMIC PUBLISHERS, BO, vol. 42, no. 17, 5 May 2007 (2007-05-05), pages 7093-7099, XP019503505, ISSN: 1573-4803, DOI: 10.1007/S10853-007-1537-6
- DATABASE WPI Week 200939 Thomson Scientific, London, GB; AN 2009-J80705 & CN 101 434 408 A (UNIV HUAZHONG SCI & TECHNOLOGY) 20 May 2009 (2009-05-20)
- Kim et Al: "Effects of Nb and Sr doping on crystal structure of epitaxial BaTiO 3 thin films on MgO substrates Effect of oxygen content on the dielectricand ferroelectricproperties of BaTiO3 thin films Effects of Nb and Sr doping on crystal structure of epitaxial BaTiO 3 thin films on MgO substrates", J. Phys. D: Appl. Phys. J. Phys. D: Appl. Phys, 18 June 2002 (2002-06-18), pages 1499-1503, XP055413569, Retrieved from the Internet: URL:http://iopscience.iop.org/article/10.1 088/0022-3727/35/13/308/pdf [retrieved on 2017-10-09]

## Description

### FIELD OF THE DISCLOSURE

The subject disclosure relates to a method of forming and utilizing sputtering targets.

### BACKGROUND

Dielectric thin films can be deposited for the purpose of fabricating electronic components by a variety of methods. One of these methods is physical vapor deposition (PVD) from a target of the desired material, otherwise known as sputtering. The sputtering method is known to people skilled in the art of thin-film deposition for the deposition of the conductive or semiconducting films (metals or conductive barriers). The method could be utilized also for the deposition of dielectrics. The sputtering process is utilizing cathode plasma discharge in vacuum resulting in the material transfer from the target to a substrate. The deposition can be done in an inert plasma sustaining gas ambient or in a reactive gas ambient, such as an inert/reactive gas mixture. Argon is frequently used as the inert plasma sustaining gas. Oxygen is a frequently used reactive gas for the deposition of oxide films. Other reactive gases such as nitrogen, nitrous oxide, etc. can be used as well. The quality of the thin dielectric film is heavily dependent on the quality and structure of the target material. Any impurities or trapped gases in the target are incorporated into the thin film, usually causing degradation of the film performance. The rate at which material is ejected from the target is also influenced by the target composition and density. A denser target can withstand higher power and have a resulting higher deposition rate and productivity of the fabrication process. Thus, the target quality and density will determine the film quality and productivity of the process. One of the challenges in fabrication of the target with a doped composition is the fact that the minor constituents (dopants) are added in substantially lower amounts (∼0.5-10% of the major constituents). If the dopants are not evenly distributed, they create local areas with different dielectric strength and density. If the dopants have multiple valent states, the uneven distribution of dopants will lead to generation of large pores, craters, or even blisters. Even distribution of the minor constituents in the composition is a key to the dielectric strength of the target, particulate control, and deposition rate of the sputtering process. Attempting to improve the distribution of the minor constituents by longer mechanical mixing/milling step results in micro-contamination of the target material with trace elements worn off the contacting parts.

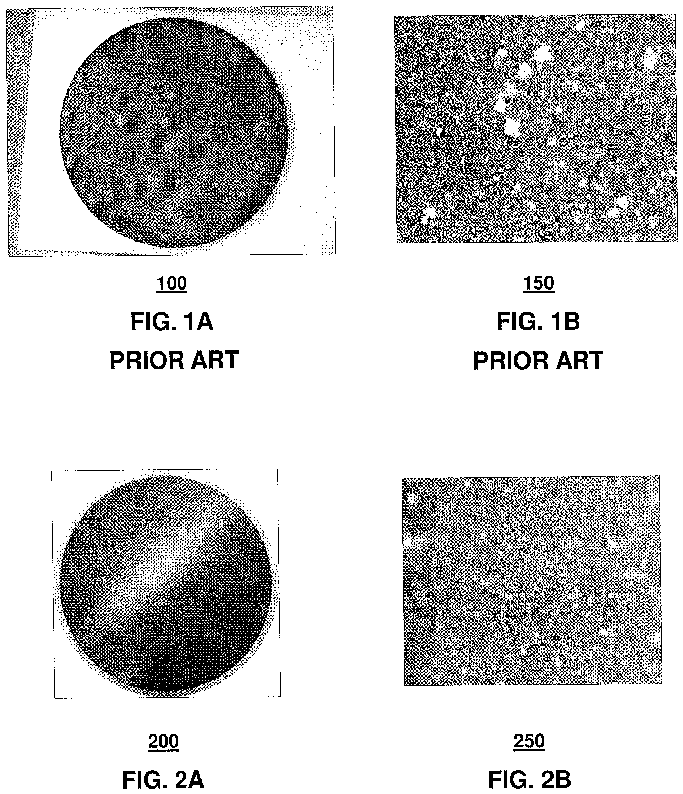

In FIG.1A, a sputtering target 100 is shown for a doped Barium-StrontiumTitanate (BST) formulation that was fabricated using a hot-press method with standard powders. The powders were prepared from calcined barium titanate powder and other standard pre-cursors using a conventional two-step method of mixing+calcination then re-mixing with dopant powders. This target using standard oxide powders is non-usable because of the heavy blistering of the material. If the hot-press process for forming the sputtering target is optimized or otherwise improved to reduce or eliminate the blistering then the grain size distribution 150 becomes too high, density of the sputtering target becomes low (e.g.,< 96% of the theoretical density) and the sputtering target material is porous as shown in FIG. 1B.

US Patent Application No. US 2011/114481 A1 discloses a lanthanum oxide-based sintered compact having lanthanum oxide as a basic component, wherein the sintered compact contains one or more of titanium oxide, zirconium oxide and hafnium oxide with the remainder being lanthanum oxide and unavoidable impurities. A method of producing a lanthanum oxide-based sintered compact, wherein La₂(CO₃)₃ powder or La₂O₃ powder as lanthanum oxide raw material powder and one or more of TiO₂, ZrO₂ and HfO₂ powders as an additive oxide are used, blending and mixing are performed so that the composition ratio of metal components of the additive oxide becomes a predetermined value based on the metal conversion, the mixed powder is thereafter heated and synthesized in the atmosphere, the synthesized material is subsequently pulverized to obtain powder, and the synthesized powder is thereafter hot pressed into a sintered compact.

US Patent Application No. US 2011/212382 A1 discloses dielectric compositions that include a compound of the formula [(M')₁₋ₓ(A')ₓ][(M")_{1-y-z},(B")_{y}(C")_{z}] O_{3-δ}(V_{O})_{δ} and protonated dielectric compositions that include a protonated dielectric compound within the formula [(M')₁₋ₓ(A')ₓ](M")_{1-y-z}(B")_{y}(C")_{z}]O_{3-δ+h}(Vₒ)_{δ}(H*)₂ₕ, as well as composite materials that employ one or more of these dielectric compounds together with an electrolyte and composite material that employ one or more of these dielectric compounds together with an electrochemally active material.

In US Patent Application No. US 2012/147524 A1 a dielectric ceramic composition contains a barium titanate based composite oxide as its main constituent, and contains a first accessory constituent including at least Al and a second accessory constituent including one or more elements selected from among Fe, Co, Ni, Cu, and Zn, wherein the content of the Al is 0.02 to 6 parts by mol with respect to 100 parts by mol of the main constituent, and the content ratio of the second accessory constituent to the Al is 0.01 to 0.4 in terms of mols. Dielectric layers are formed from a sintered body of the dielectric ceramic composition. The addition of various types of accessory elements such as rare-earth elements is possible, if necessary.

US Patent Application No. US 2008/152530 A1 relates to methods of making a ferroelectric powder and ceramics having the steps of mixing a polymer and a metal oxide precursor mixture within a mill, milling the polymer/precursor mixture, drying the mixture, burning the dried solid, grinding the solid, and calcinating the solid to a ferroelectric powder. The production of ceramics further involves compressing the ferroelectric powder and sintering the compression.

The article of Sung-Soo Ryu et Al. entitled "Solid-state synthesis of nano-sized BaTiO3 powder with high tetragonality" (JOURNAL OF MATERIALS SCIENCE, vol. 42, no.17, 5 May 2007, pp.7093-7099) describes the solid state synthesis of a 2% Ca-doped BaTiO₃ powder and discloses its preparation by mixing of TiO₂, BaCO₃ and CaCO₃ powders, the latter having an average particle size of 62 nm; spray-drying, calcining and pulverizing.

CN Patent Application CN 101 434 408 A describes a Pr-doped Ba Ti oxide "BTO" target prepared by mixing Bi₂O3, TiO₂ and Pr₆O₁₂, grinding and milling, calcining, milling, screening and hot press sintering. The thin film is obtained by sputtering during 2-5h.

The article of Kim et Al. entitled "Effects of Nb and Sr doping on crystal structure of epitaxial BaTiO3 thin films on MgO substrates" (J. Phys. D: Appl. Phys, 18 June 2002, pp.1499-1503) discloses the manufacture of a Nb- or Sr-doped BaTiO₃ target by mixing together Nb₂O₅ or SrCO₃ powder with BaCO₃ and TiO₂ powders. The deposited film is 200 nm thick for a deposition time of 3h.

### BRIEF DESCRIPTION OF THE DRAWINGS

Reference will now be made to the accompanying drawings, which are not necessarily drawn to scale, and wherein:
FIGs. 1A and 1B depict a prior art high-K dielectric sputtering target and prior art non-uniform grain size distribution for the prior art high-K dielectric sputtering target formed from a contemporary hot-press fabrication process;
FIGs. 2A and 2B depict an illustrative embodiment of a high-K dielectric sputtering target and grain size distribution for the high-K dielectric sputtering target formed from a fabrication process according to the exemplary embodiments;
FIG. 2C depicts a table for comparison of density and deposition rate between a high-K dielectric sputtering target of the exemplary embodiments and prior art sputtering targets formed from prior art hot-press processes; and
FIG. 3 depicts an exemplary method that can be used for fabricating the sputtering target of FIG. 2A.

### DETAILED DESCRIPTION

The subject disclosure describes, among other things, illustrative embodiments of a sputtering target and a method of forming the sputtering target to enable fabrication of desired electrical or optical components, such as components that include high-K dielectric thin film(s). In one or more embodiments, the composition includes major and minor constituents. In one or more embodiments, the sputtering target is used in a PVD process that enables a higher deposition rate (e.g., at least 12 nanometers per minute). In one or more embodiments, the sputtering target has a higher density (e.g., at least 99% of the theoretical density). In one or more embodiments, the sputtering target can be used in a PVD process to form a BST layer, such as for use in a variable capacitor. In one or more embodiments, the process allows application of higher power to the target than previously possible with more standard targets with a consequent increase in the productivity of the deposition process and therefore increased capacity and reduced manufacturing cost. In one or more embodiments, the process allows one mixing step to significantly reduce contamination from the mixing step in the final sputtering target.

Other references, such as US Patent Nos. 8,154,850, 8,194,837, 7,224,040, have shown how to fabricate fixed and tunable capacitors using dielectric thin films deposited by the sputtering method. Electronic and optical devices other than capacitors can also be fabricated with dielectric films deposited by the sputtering method. Examples include, but are not limited to: non-volatile memories, film bulk acoustic resonators (FBAR) for filtering and signal processing, anti-reflection coatings for lenses and waveguides for integrated optics. Other references demonstrate the advantages of using doped oxide formulations in electronic devices: US Patent Nos.6,683,516, 6,876,279, 6,774,077, 6,905,989, 7,297,650.

In one or more embodiments, the precursors for forming the sputtering target, such as major and minor constituents, can be selected based on thermal decomposition properties. In one embodiment, some or all of the thermally decomposable precursors for the major constituents can be selected based on their material properties of being thermally decomposable at a temperature of equal to or lower than 60% of the final crystallization temperature of the resulting powder. In one or more embodiments, thermal decomposition of such components can occur at an equal or lower temperature than the temperature of a solid state reaction forming the given composition.

In one or more embodiments, the minor constituents can be amorphous or near-amorphous, including nanopowders, gels, and/or alkoxides. In one or more embodiments, the major and minor constituents can be mixed in a single mixing step and then processed (e.g., drying, calcining, pulverizing, and/or sieve separating) so that a resulting powder can be hot-pressed to form a desired sputtering target. Other embodiments are contemplated by the subject disclosure.

One embodiment of the subject disclosure is a method including selecting a first major constituent, a second major constituent and a minor constituent. The first major constituent is TiO2. The second major constituent is selected from a group consisting essentially of a carbonate or a carboxylate (acetate, oxalate, propionate) or combination thereof. The minor constituent is selected from a group consisting essentially of a nanopowder, a gel, an alkoxide or combinations thereof. The method includes mixing the first major constituent, the second major constituent and the minor constituent in a single mixing step to provide a mixture of constituents. The mixing could be dry or wet. The method includes drying the mixture of constituents to provide a dried mixture of constituents, and calcining the dried mixture of constituents to provide a fully reacted crystalline material of the given composition. The method includes pulverizing and sieve separating the reacted material to provide a precursor powder. The reacted crystalline powder of the given composition and of the certain grain size is a precursor material for the hot press or the isostatic cold press formation of a sputtering target.

One embodiment of the subject disclosure can be a method that includes selecting a major constituent and a minor constituent. The major constituent can be selected from a group of major constituents that have a thermal decomposition temperature of 50% to 60% of the final crystallization temperature of a powder of constituents. The minor constituent can be selected from a group of minor constituents that are amorphous. The method includes mixing the major constituent and the minor constituent in a single mixing step to provide a mixture of constituents. The method includes drying the mixture of constituents to provide a dried mixture of constituents, and calcining the dried mixture of constituents to provide a fully reacted mixture of constituents. The method includes milling or pulverizing the calcinated mixture of constituents to provide the powder of constituents. The grain size distribution and thermal stability of this powder is configured for being hot-pressed to form a compositionally uniform and dense sputtering target.

One embodiment of the subject disclosure can be a method that includes selecting a first major constituent, a second major constituent and a minor constituent for forming a high-K dielectric material. The method includes mixing the first major constituent, the second major constituent and the minor constituent in a single mixing step to provide a mixture of constituents. The method includes drying the mixture of constituents to provide a dried mixture of constituents and calcining the dried mixture of constituents to provide a fully reacted mixture of constituents. The method includes milling or pulverizing the reacted mixture of constituents to provide a powder of constituents. The powder of constituents is configured for being hot-pressed to form a sputtering target for use in a physical vapor deposition process to form the dielectric material at a deposition rate of at least twelve nanometers per minute.

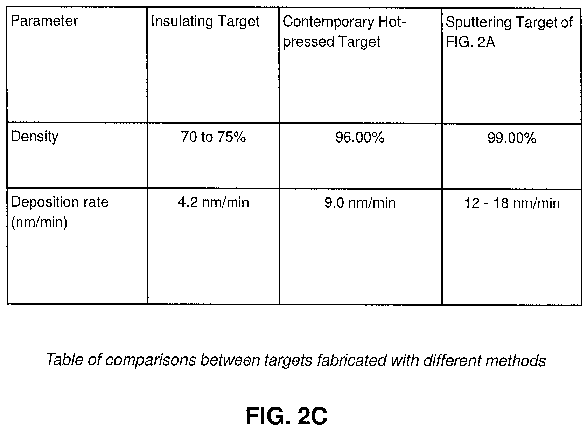

Referring to FIGs 2A and 2B, a sputtering target 200 and corresponding grain structure 250 is shown for a sputtering target fabricated according to the exemplary embodiments. The grain structure 250 shows small and uniform grains for the sputtering target 200 as is desired. In one or more embodiments, the sputtering target can be used to deposit films at between 12 and 18 nm/min. Referring to FIG. 2C, a comparison with enabled deposition rates for other sputtering targets is illustrated. As can be seen, the insulating target can only manage 4.2 nm/min maximum deposition rate and the sputtering target with a large grain-size distribution 150 can only be used up to 9 nm/min. This represents a large increase in the productivity of the deposition process with consequent cost reduction for the eventual product and capacity increase for the manufacturing facility.

Sputtering target 200 can be formed through a process that selects particular precursor materials for forming a powder. The materials can be selected based on various criteria, including thermal decomposition properties, such as a particular thermal decomposition temperature (e.g., of <50-60% of the final crystallization temperature of the resulting powder - although other thermal decomposition temperatures (or ranges of temperatures) can be utilized). Other criteria can include structure, such as amorphous or near amorphous structure of the precursor.

In one embodiment, all of the thermally decomposable precursors for the major constituents are thermally decomposable at a temperature of 50-60% of the final crystallization temperature of powder. In another embodiment, the thermal decomposition of all of the decomposable precursors for the major constituents occurs at an equal or lower temperature than the temperature of the solid state reaction forming the major constituent(s). In one or more embodiments, more than one major constituent and at least one minor constituent is utilized in forming the sputtering target.

In one or more embodiments, the major constituent(s) for the sputtering target 200 can include thermally decomposable precursor(s) of one or more of metal carbonates and carboxylates (such as oxalates or acetates). In one or more embodiments, the minor constituent(s) for the sputtering target 200 includes liquids (such as sols, gels, and/or alkoxides) or solids (such as xero-gels, anhydrous amorphous precipitates, and/or nanopowders).

For example, nanopowder precursors for the minor constituents can include metal oxide nanopowders including rare-earth metal oxide, hydroxide, titanate, zirconate, and/or niobate nanopowders. As another example, sol-gel or gel chemically derived precursors for the minor constituents can include metal titanate, tantalite, niobate, zirconate sols and gels both in organic solvents or aqueous. As another example, alkoxides and partially hydrolyzed alkoxides for the minor constituents can include metal alkoxides such as (but not limited to) magnesium ethoxide, aluminum isopropoxide and/or rare-earth alkoxides. As another example, partially hydrolyzed alkoxides can also include hydroxyacetates, hydroxyoxalates or hydroxypropionates.

As another example, hydroxides for the minor constituents can include magnesium hydroxide, aluminum hydroxide, and so forth. As another example, carboxylates include acetates, formiates, oxalates or propionates (both hydrated and anhydrous). In one or more embodiments, any metal alkoxide (except of alkoxides of the group 1 metals) can be used in the partly hydrolyzed form.

In one or more embodiments, the major and minor constituents for sputtering target 200 are combined in a one-step mixing of all the precursors. A calcination can be performed at a temperature selected for the mixture that provides a desired grain size, such as a calcination temperature of 1200° C for a BST powder. Other precursors and constituents can be used for forming sputtering targets which can result in other calcination temperatures being implemented, such as utilizing other titanate-based powders where a lower calcination temperature is utilized.

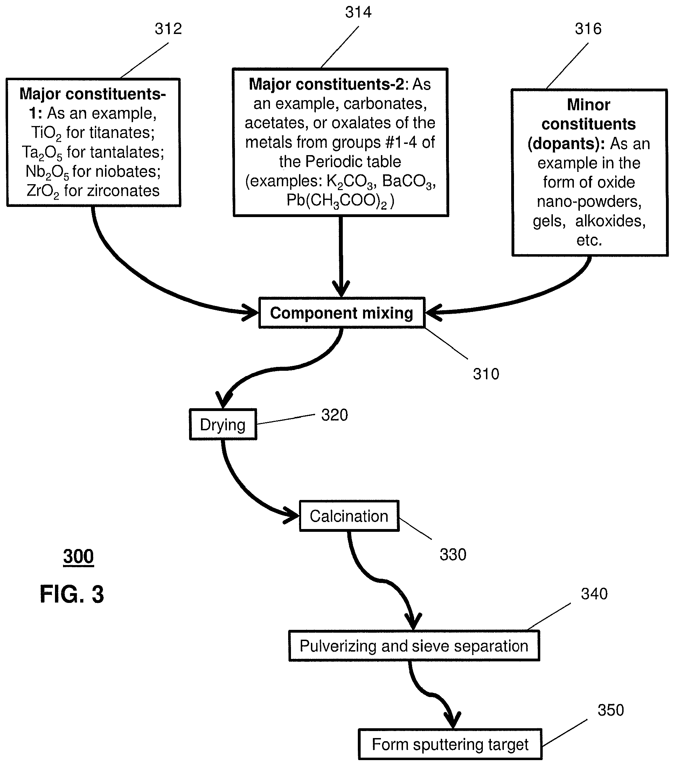

Referring to FIG. 3, a method 300 is illustrated for fabricating a powder and forming a sputtering target from the powder. Method 300 can be utilized for forming sputtering target 200 and can be utilized for forming other sputtering targets that can be composed of various materials including BST, other titanates, and so forth. Method 300 is not intended to be limited to the steps illustrated in FIG. 3 and can include more or less steps than is depicted.

Method 300 includes mixing of various components at 310. The mixing is a single mixing step and can be performed using various techniques including ball milling, vibrational milling and/or mechanical grinding, which may depend on the selected components. The components for mixing can be selected based on various criteria associated with the powder that will form the sputtering target. For example, the components can be selected based on thermal decomposition properties of one or more of the components, such as the thermal decomposition of a precursor of a major constituent satisfying a temperature threshold with respect to the crystallization temperature of the resulting powder. In the example of method 300, two major constituents and one minor constituent are being selected to form a powder that can be hot-pressed into a sputtering target for PVD deposition of a high K dielectric thin film.

The particular number and types of major and minor constituents can vary depending on the sputtering target that is to be formed. In this example of method 300, the first major constituent is TiO₂ for titanates. Continuing with this example, the second major constituent can be carbonates, acetates, or oxalates of the metals from groups number 1-4 of the Periodic table (e.g., K₂CO₃, BaCO₃, and/or Pb(CH₃COO)₂). The minor constituents for this example of method 300 can be in the form of oxide nanopowders, gels, alkoxides, and so forth. Other major and/or minor constituents can also be utilized, including the other examples described in the appended claims.

At 320, the mixture of constituents can are dried. The particular drying temperature (e.g., 130° C) and drying time (e.g., 6 hrs) can vary and can be selected based on the constituents that have been mixed together, the batch size, and the equipment used. At 330, the dried mixture of constituents can be calcinated. The particular calcination temperature (e.g., 1200° C) and calcination time (e.g., 12 hrs) can vary and can be selected based on the constituents that have been mixed together and the desired sputtering target, such as a BST sputtering target.

At 340, the reacted mixture of constituents can be further processed to obtain the desired powder that will form the sputtering target. For example, the reacted mixture of constituents can be pulverized and separated (e.g., via a sieve separation technique). Other processing techniques for separation can also be utilized such as electrostatic, centrifugal and/or cyclonic separation.

In one embodiment at 350, a sputtering target is formed from the powder using a hot-press method. The temperature, pressure and duration of the hot-press method can vary and can be based on the powder and/or the desired sputtering target to be formed. For example, a BST sputtering target can undergo a hot-press at a temperature of 1000°C to 2000°C. It should be understood that method 300 is but one example of a sputtering target that can be fabricated according to the exemplary embodiments, and the particular materials, temperatures, pressures, timing and so forth, can vary based on a number of factors including the desired sputtering target that is to be formed, a desired density of the sputtering target, and/or a desired deposition rate for the PVD process that will utilize the sputtering target. The exact fabrication method for the electrical components (e.g., capacitors) can be performed in various ways utilizing the exemplary sputtering target described herein, such as described in the above referenced US Patents.

In one or more embodiments, the sputtering target provides dielectric films for thin-film capacitors which exhibit improved physical density, improved dielectric strength, high tuning, and improved uniformity of capacitance, breakdown voltage and thickness.

One or more of the exemplary embodiments can be used for fabricating a sputtering target(s) used in a PVD sputtering process for producing dielectric layers of an electrical component (e.g., a voltage tunable variable capacitor), such as a high permittivity (High-K) dielectric perovskite or pyrochlore material of various stoichiometric or non-stoichiometric chemical compositions. The dielectric layers can be highly tunable. Examples include compounds containing Barium Strontium Titanium Oxide or (BaSr)TiO₃, SBT, SBM, PZT or PLZT, and doped formulations of each. Other electrically tunable dielectric materials may be used partially or entirely in place of BST. An example is strontium bismuth tantalate (SBT). Additional electronically tunable ferroelectrics can include other electrically tunable compositions of high-K dielectrics, such as BaTiO₃, SrTiO₃, CaTiO₃, members of the lead titanate family such as PbTiO₃, Pb(ZrxTi₁₋ₓ)O₃ (PZT), (Pb,Sr)(ZrₓTi₁₋ₓ)O₃, (Pb,La)(ZxTi₁₋ₓ)O₃ (PLZT).

In other embodiments, additional minor additives (e.g., in amounts of from about 0.1 to about 10 weight percent) can be utilized in the electrical component to additionally improve the electronic properties, such as of the films. These minor additives can include various materials, such as CaZrO₃, BaZrO₃, SrZrO₃, BaSnO₃, CaSnO₃, MgSnO₃, Bi₂O_{3/2}SnO₂, Nd₂O₃, Pr₇O₁₁, Yb₂O₃, Ho₂O₃, La₂O₃, MgNb₂O₆, SrNb₂O₆, BaNb₂O₆, MgTa₂O₆, BaTa₂O₆ and Ta₂O₃.

In one or more embodiments, films of tunable dielectric composites may comprise Ba₁₋ₓSrₓTiO₃ (BST) (or other tunable dielectric), in combination with at least one non-tunable dielectric phase including Group 2A elements in the form of oxide, silicate, zirconate, aluminate, tantalate, niobate or a mixture of thereof. Examples include MgO, MgTiO₃, MgZrO₃, MgSrZrTiO₆, Mg₂SiO₄, MgAl₂O₄, CaO, CaSiO₃, CaTiO₃, BaSiO₃ and SrSiO₃. The non-tunable dielectric phases may be any combination of the above, e.g., MgO combined with MgTiO₃, MgO combined with MgSrZrTiO₆, MgO combined with Mg₂SiO₄, MgO combined with Mg₂SiO₄, Mg₂SiO₄ combined with CaTiO₃. These compositions can be BST (or other tunable dielectric) and one of these components, or two or more of these components in quantities from 0.1 weight percent to 10 weight percent with BST (or other tunable dielectric) weight ratios of 99.9 weight percent to 90 weight percent.

In addition to Group 2A metals, one or more of the exemplary embodiments can utilize metal oxides, silicates, zirconates, aluminates, tantalates, niobates or a combination thereof that include metals from Group 1A (alkali metals),e.g., Li, Na, K and Rb.. For instance, alkali metal silicates may include sodium silicates such as Na₂SiO₃ and NaSiO₃₋₅H2O, and lithium-containing silicates such as LiAlSiO₄, Li₂SiO₃ and Li₄SiO₄. Metals from Groups 3A, 4A and some transition metals of the Periodic Table may also be suitable constituents of the metal silicate phase. Additional oxides and silicates may include but not limited to Al₂O₃, SiO₂, ZrO₂, Al₂Si₂O₇, ZrSiO₄, KAlSi₂O₆, NaAlSi₂O₆, CaAl₂Si₂O₈, CaMgSi₂O₆, BaTiSi₃O₉ and Zn₂SiO₄. Metals from other Groups of the Periodic Table may also be suitable constituents of the metal oxide phases. For example, oxides and/or other compounds of refractory metals such as Ti, V, Cr, Mn, Zr, Nb, Mo, Hf, Ta, and W may be used. Furthermore, metals such as Al, Si, Sn, Pb, and Bi may be used in the form of oxides and/or other compounds. In addition, the metal oxide phases may comprise rare earth elements such as La, Ce, Pr, Nd, Pm, Sm, Eu, Gd, Tb, Dy, Ho, Er, Tm, Yb, Lu in the form of oxides and/or other compounds solely or in composition with one or more of the above mentioned additives.

In one or more embodiments, high-capacity or tunable monolithic thin film capacitors can be formed from the doped oxide films deposited from the target. These integrated capacitors require electrode layers and/or interconnects formed, for example, from a conductive thin-film material (e.g., Pt, conductive oxides such as SrRuO₃, LaNiO₃, LaMn₁₋ₓCoₓO₃, and other metals such as Ir, Au, Cu, and W). The electrode layers could be a single metal, or a multilayer structure comprised of two or more metals or combinations of metals with conductive oxides. These multilayer structures could include conductive barriers, such as but not limited to TiₓN_{y}, TiW, TaₓN_{y}, Taₓ(ON)_{y}, and anti-reflective layers.

Other uses for the invention include multi-component dielectric films deposited by the sputtering method for optical coatings and transparent conductive films for electro-optical devices or components.

The illustrations of embodiments described herein are intended to provide a general understanding of the structure of various embodiments, and they are not intended to serve as a complete description of all the elements and features of apparatus and systems that might make use of the structures described herein. Figures are also merely representational and may not be drawn to scale. Certain proportions thereof may be exaggerated, while others may be minimized. Accordingly, the specification and drawings are to be regarded in an illustrative rather than a restrictive sense.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim.

## Claims

1. A method, comprising:
selecting two or more major constituents and at least one dopant, wherein the two or more major constituents consist of a first major constituent and at least one second major constituent, wherein the first major constituent is TiO₂, wherein the second major constituent is selected from a group consisting essentially of a carbonate, an acetate, an oxalate, a propionate or combinations thereof, and wherein the dopant is selected from a group consisting essentially of a nanopowder, a gel, an alkoxide or combinations thereof and added in amounts from 0.5 to 10 % of the major constituents;
mixing the first major constituent, the second major constituent and the dopant in a single mixing step to provide a mixture of constituents;
drying the mixture of constituents to provide a dried mixture of constituents;
calcining the dried mixture of constituents to provide a fully reacted mixture of constituents;
pulverizing and separating the reacted mixture of constituents to provide a powder of constituents;
hot-pressing the powder of constituents to form a target for physical vapor deposition; and
performing physical vapor deposition by sputtering using the target to form a multicomponent dielectric thin film,
wherein the physical vapor deposition is performed at a deposition rate of at least twelve nanometers per minute, and wherein the sputtering target has a density of at least 99%.

2. The method of claim 1, wherein the second major constituent is K₂CO₃.

3. The method of claim 1, wherein the calcining is performed within 100°C of the temperature of solid state reaction of the constituents.

4. The method of claim 1, wherein the second major constituent is one of BaCO₃ or Pb(CH₃COO)₂.

5. The method of claim 1, wherein the nanopowder is selected from a group consisting essentially of a rare-earth metal oxide nanopowder, a hydroxide nanopowder, a titanate nanopowder, a zirconate nanopowder, a niobate nanopowder or combinations thereof, and wherein the alkoxide is selected from a group consisting essentially of magnesium ethoxide, aluminum isopropoxide, rare-earth alkoxide, hydroxyacetate, hydroxyoxalate, hydroxypropionate and combinations thereof.

6. The method of claim 1, wherein the major constituents are selected from a group of major constituents that have a thermal decomposition temperature of 50% to 60% of the final crystallization temperature of the powder of constituents.

7. The method of claim 6, wherein the group of dopants includes a rare-earth metal oxide nanopowder, a hydroxide nanopowder, a titanate nanopowder, a zirconate nanopowder, a niobate nanopowder, magnesium ethoxide, aluminum isopropoxide, rare-earth alkoxide, hydroxyacetate, hydroxyoxalate, hydroxypropionate and combinations thereof.

8. The method of claim 6, wherein the dopant is selected from a group of dopants that are amorphous, and wherein the calcining of the dried mixture of constituents is performed within 100°C of the temperature of solid state reaction of the constituents.

## Patentansprüche

1. Verfahren, bei dem man:
zwei oder mehr Hauptbestandteile und mindestens einen Dotierstoff auswählt, wobei die zwei oder mehr Hauptbestandteile aus einem ersten Hauptbestandteil und mindestens einem zweiten Hauptbestandteil bestehen, wobei es sich bei dem ersten Hauptbestandteil um TiO₂ handelt, wobei der zweite Hauptbestandteil aus einer Gruppe ausgewählt wird, die im Wesentlichen aus einem Carbonat, einem Acetat, einem Oxalat, einem Propionat oder Kombinationen davon besteht und wobei der Dotierstoff aus einer Gruppe ausgewählt wird, die im Wesentlichen aus einem Nanopulver, einem Gel, einem Alkoholat oder Kombinationen davon besteht und in Mengen von 0,5 bis 10 % der Hauptbestandteile zugegeben wird;
den ersten Hauptbestandteil, den zweiten Hauptbestandteil und den Dotierstoff in einem einzigen Mischschritt zur Bereitstellung einer Mischung von Bestandteilen mischt;
die Mischung von Bestandteilen zur Bereitstellung einer getrockneten Mischung von Bestandteilen trocknet;
die getrocknete Mischung von Bestandteilen zur Bereitstellung einer vollständig umgesetzten Mischung von Bestandteilen calciniert;
die umgesetzte Mischung von Bestandteilen zur Bereitstellung eines Pulvers von Bestandteilen fein zermahlt und trennt;
das Pulver von Bestandteilen zur Bildung eines Targets für die physikalische Gasphasenabscheidung heißpresst; und
zur Bildung einer mehrkomponentigen dielektrischen Dünnschichtfolie eine physikalische Gasphasenabscheidung durch Sputtern unter Verwendung des Targets durchführt,
wobei man die physikalische Gasphasenabscheidung bei einer Abscheidungsrate von mindestens zwölf Nanometern je Minute durchführt und wobei das Sputter-Target eine Dichte von mindestens 99% aufweist.

2. Verfahren nach Anspruch 1, wobei es sich bei dem zweiten Hauptbestandteil um K₂CO₃ handelt.

3. Verfahren nach Anspruch 1, wobei man das Calcinieren innerhalb von 100 °C der Temperatur der Festkörperreaktion der Bestandteile durchführt.

4. Verfahren nach Anspruch 1, wobei es sich bei dem zweiten Hauptbestandteil um BaCO₃ oder Pb(CH₃COO)₂ handelt.

5. Verfahren nach Anspruch 1, wobei das Nanopulver aus einer Gruppe ausgewählt wird, die im Wesentlichen aus einem Nanopulver eines Seltenerdmetalloxids, einem Nanopulver eines Hydroxids, einem Nanopulver eines Titanats, einem Nanopulver eines Zirconats, einem Nanopulver eines Niobats oder Kombinationen davon besteht, und wobei das Alkoholat aus einer Gruppe ausgewählt wird, die im Wesentlichen aus Magnesiumethanolat, Aluminiumisopropanolat, Seltenerd-Alkoholat, Hydroxyacetat, Hydroxyoxalat, Hydroxypropionat und Kombinationen davon besteht.

6. Verfahren nach Anspruch 1, wobei die Hauptbestandteile aus einer Gruppe von Hauptbestandteilen ausgewählt werden, die eine thermische Zersetzungstemperatur von 50 % bis 60 % der Kristallisationsendtemperatur des Pulvers von Bestandteilen aufweisen.

7. Verfahren nach Anspruch 6, wobei die Gruppe an Dotierstoffen ein Nanopulver eines Seltenerdmetalloxids, ein Nanopulver eines Hydroxids, ein Nanopulver eines Titanats, ein Nanopulver eines Zirconats, ein Nanopulver eines Niobats, Magnesiumethanolat, Aluminiumisopropanolat, Seltenerd-Alkoholat, Hydroxyacetat, Hydroxyoxalat, Hydroxypropionat und Kombinationen davon einschließt.

8. Verfahren nach Anspruch 6, wobei der Dotierstoff aus einer Gruppe an Dotierstoffen ausgewählt wird, die amorph sind, und wobei man das Calcinieren der getrockneten Mischung von Bestandteilen innerhalb von 100 °C der Temperatur der Festkörperreaktion der Bestandteile durchführt.

## Revendications

1. Procédé, comprenant :
la sélection de deux ou plus de deux constituants principaux et d'au moins un dopant, dans lequel les deux ou plus de deux constituants principaux consistent en un premier constituant principal et au moins un deuxième constituant principal, dans lequel le premier constituant principal est TiO₂, dans lequel le deuxième constituant principal est sélectionné dans un groupe consistant essentiellement en un carbonate, un acétate, un oxalate, un propionate ou des combinaisons de ceux-ci et dans lequel le dopant est sélectionné dans un groupe consistant essentiellement en une nanopoudre, un gel, un alcoolate ou des combinaisons de ceux-ci et ajouté en quantités de 0,5 à 10 % des constituants principaux ;
le mélange du premier constituant principal, du deuxième constituant principal et du dopant dans une unique étape de mélange pour fournir un mélange de constituants ;
le séchage du mélange de constituants pour fournir un mélange de constituants séché ;
la calcination du mélange de constituants séché pour fournir un mélange de constituants ayant complètement réagi ;
la pulvérisation et la séparation du mélange de constituants ayant réagi pour fournir une poudre de constituants ;
la compression à chaud de la poudre de constituants pour former une cible pour un dépôt physique en phase vapeur ; et
la mise en œuvre d'un dépôt physique en phase vapeur par pulvérisation cathodique à l'aide de la cible pour former un film mince diélectrique à plusieurs composants,
dans lequel le dépôt physique en phase vapeur est mis en œuvre à une vitesse de dépôt d'au moins douze nanomètres par minute et dans lequel la cible de pulvérisation cathodique a une densité d'au moins 99 %.

2. Procédé selon la revendication 1, dans lequel le deuxième constituant principal est K₂CO₃.

3. Procédé selon la revendication 1, dans lequel la calcination est mise en œuvre à moins de 100 °C de la température de réaction des constituants à l'état solide.

4. Procédé selon la revendication 1, dans lequel le deuxième constituant principal est l'un de BaCO₃ ou Pb(CH₃COO)₂.

5. Procédé selon la revendication 1, dans lequel la nanopoudre est sélectionnée dans un groupe consistant essentiellement en une nanopoudre d'oxyde de métal des terres rares, une nanopoudre d'hydroxyde, une nanopoudre de titanate, une nanopoudre de zirconate, une nanopoudre de niobate ou des combinaisons de celles-ci et dans lequel l'alcoolate est sélectionné dans un groupe consistant essentiellement en l'éthylate de magnésium, l'isopropylate d'aluminium, un alcoolate de terre rare, un hydroxyacétate, un hydroxyoxalate, un hydroxypropionate et des combinaisons de ceux-ci.

6. Procédé selon la revendication 1, dans lequel les constituants principaux sont sélectionnés dans un groupe de constituants principaux qui ont une température de décomposition thermique de 50 % à 60 % de la température de cristallisation finale de la poudre de constituants.

7. Procédé selon la revendication 6, dans lequel le groupe de dopants inclut une nanopoudre d'oxyde de métal des terres rares, une nanopoudre d'hydroxyde, une nanopoudre de titanate, une nanopoudre de zirconate, une nanopoudre de niobate, l'éthylate de magnésium, l'isopropylate d'aluminium, un alcoolate de terre rare, un hydroxyacétate, un hydroxyoxalate, un hydroxypropionate et des combinaisons de ceux-ci.

8. Procédé selon la revendication 6, dans lequel le dopant est sélectionné dans un groupe de dopants qui sont amorphes et dans lequel la calcination du mélange de constituants séché est mise en œuvre à moins de 100 °C de la température de réaction des constituants à l'état solide.
